# EUROPEAN PATENT SPECIFICATION

(11) **EP 0 418 870 B1**
(45) Date of publication and mention of the grant of the patent: **04.09.1996**
(21) Application number: 90118049.7
(22) Date of filing: 19.09.1990
(51) Int. Cl.: G03F 7/037

(54) **Radiation sensitive polymer composition**
Strahlungsempfindliche Kunststoffzusammensetzung
Composition polymerique, sensible aux radiations

(30) Priority: 19.09.1989 JP 244670/89
(43) Date of publication of application: 27.03.1991
(73) Proprietor: TORAY INDUSTRIES, INC., Tokyo (JP)
(72) Inventor: Tomikawa, Masao, Muko-shi, Kyoto-fu (JP); Asano, Masaya, Otsu-shi, Shiga-ken (JP)
(74) Representative: Kador & Partner

(56) References cited:
- EP-A- 0 119 719
- EP-A- 0 137 655
- DE-A- 2 914 619

## Description

### Background of the Invention

### (1) Field of the Invention

The present invention relates to a radiation-sensitive polymer composition and more particularly to a photosensitive polyimide composition improved remarkably in developability.

### (2) Description of the Prior Art

As a photosensitive polyimide composition there is known a composition (see, for example, U.S. Patent No. 4,243,743) prepared by adding a compound containing a radiation-dimerizable or radiation-polymerizable carbon-carbon double bond and an amino group or a quaternary ammonium salt to a polyamide-acid. Although a film formed from such composition has good mechanical properties such as strength and elongation, there still remains a problem with respect to its developability.

Also known are photosensitive polyimide precursor compositions (see, for example, U.S. Patent Nos. 3,957,512 and 4,040,831) prepared by introducing ester groups into a polyamide-acid. Although films formed from these compositions are relatively good in developability, they are inferior in such mechanical properties as strength and elongation.

It is the object of the present invention to remedy the above-mentioned drawbacks of the prior art and provide a radiation-sensitive polymer composition capable of affording a film superior in both developability and mechanical properties such as strength and elongation. The term "developability" means that development is performed easily and relief patterns obtained have good edge sharpness.

### Summary of the Invention

The present invention resides in a radiation-sensitive polymer composition comprising:
(a) a polymer having repeating units represented by the general formula [1] 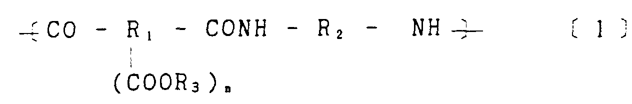 wherein R₁ is a trivalent or tetravalent organic residue having at least two carbon atoms, R₂ is a divalent organic residue having at least two carbon atoms, R₃ is hydrogen or an alkali metal counter ion, and n is 1 or 2;
(b) a compound containing a radiation-dimerizable or radiation-polymerizable unsaturated bond and an amino group or a quaternary ammonium salt;
(c) a non-alicyclic organic compound having a boiling point not lower that 120°C, containing at least one functional linkage selected from the group consisting of ester linkage, ether linkage, and ketone linkage, and containing neither amino group nor hydrodyl group; and
(d) optionally a sensitizer.

### Detailed Description of the Preferred Embodiments

The polymer (a) and the radiation-dimerizable or -polymerizable compound (b) both used in the present invention are described in U.S Patent No. 4,608,333 of the same assignee as that in the present application.

The polymer (a) having repeating units of the general formula [1] is a polymer which may be converted by heating or in the presence of an appropriate catalyst to a polymer having imide rings or other cyclic structure (hereinafter referred to as "polyimide").

In the above formula [1] , R₁ is a trivalent or tetravalent organic residue having at least two carbon atoms. From the view point of the heat resistance of the resulting polyimide, a trivalent or tetravalent aromatic or heteroaromatic residue having 6 to 30 carbon atoms is preferred as R₁.

Preferred examples of R₁ include 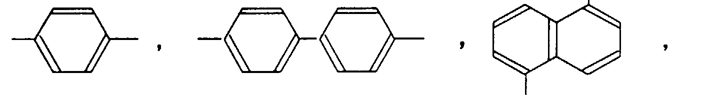 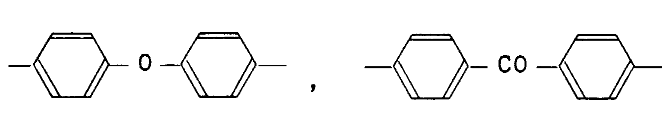 and the like
wherein each of the divalent bonds is a bond constituting an amide linkage of the main chain of the polymer, and the group COOR₃ attached to R₁ is located at an ortho-position with respect to the above bonding, i.e. the amide linkage but the bond to COOR₃ is omitted in the above structure.

The polymer (a) may be either a polymer containing one kind of R₁ as mentioned above or a copolymer containing two or more kinds of R₁.

Especially preferred examples include

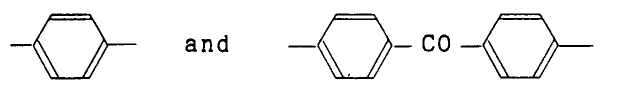

In the above formula [1] , R₂ is a divalent organic residue having at least two carbon atoms. From the view point of the heat resistance of the resulting polyimide a divalent aromatic or heteroaromatic residue having 6 to 30 carbon atoms is preferred as R₂.

Preferred examples of R₂ include 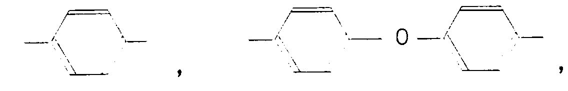 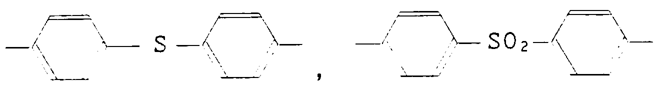 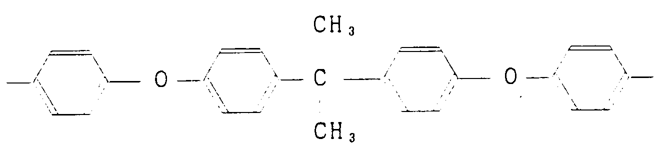 and the like
wherein the bonding-represents that between R₂ and the amide linkage in the main chain. The benzene ring of R₂ may contain substituents such as an amino group, an amide group, a carboxyl group and sulfonamide group, so long as they give no bad effect on the heat resistance of the resulting polyimide.

Preferred examples of R₂ containing a substituent are include 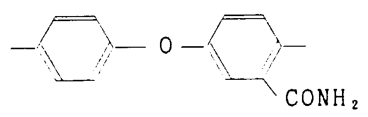 and

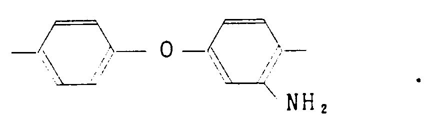

The polymer (a) may be either a polymer containing one kind of R₂ or a copolymer containing two or more of R₂.

Further, the polymer (a) may contain an aliphatic divalent group having a siloxane structure to improve the adhesive property of the resulting polyimide in an amount not to significantly degrading the heat resistance of the polyimide.

Preferable example is 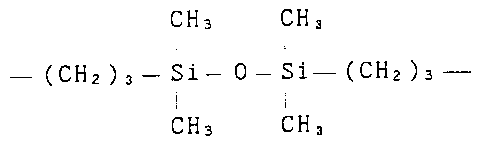 and the like.

The polymer (a) may be prepared typically by reacting a tetracarboxylic dianhydride with a diamine.

Preferred examples of the polymer(a) include polyamide-acids such as a reaction product of pyromellitic dianhydride and 4,4′ -diaminodiphenyl ether, a reaction product of 3,3′ ,4,4′ -benzophenone-tetracarboxylic dianhydride with 4,4′ -diaminodiphenyl ether, a reaction product of 3,3′ ,4,4′ - biphenyltetracarboxylic dianhydride with 4,4′ - diaminodiphenyl ether, a reaction product of pyromellitic dianhydride with 3,3′ -(or 4,4 ′ -) diaminodiphenylsulfone, a reaction product of pyromellitic dianhydride and 3,3 ′ ,4,4′ - benzophenone tetracarboxylic dianhydride with para-phenylene diamine, a reaction product of pyromellitic dianhydride and 3,3 ′ ,4,4′ - biphenyl tetracarboxylic dianhydride with para-phenylene diamine, a reaction product of 3,3′ ,4,4′ -benzophenone tetracarboxylic dianhydride with 3,3′ -(or 4,4′ -) diaminodiphenylsulfone, a reaction product of 3,3′ ,4,4′ -biphenyl tetracarboxylic dianhydride with 3,3′ -(or 4,4′ -) diaminodiphenylsulfone, a reaction product of pyromellitic dianhydride with 4,4 ′ - diaminodiphenylsulfide, a reaction product of 3,3′ ,4,4′ - benzophenone tetracarboxylic dianhydride with 4,4′- diaminodiphenylsulfide, a reaction product of 3,3′ ,4,4′ - biphenyl tetracarboxylic dianhydride with 4,4′ - diaminodiphenylsulfide, a reaction product of 3,3′ ,4,4′ - benzophenone tetracarboxylic dianhydride with para-phenylene diamine, a reaction product of 3,3′ ,4,4′ - biphenyl tetracarboxylic dianhydride with para-phenylene diamine, a reaction product of 3,3 ′ ,4,4′ - diphenylether tetracarboxylic dianhydride with 4,4′- diaminodiphenyl ether, a reaction product of 3,3 ′ ,4,4′ -diphenylether tetracarboxylic dianhydride with para-phenylene dimine, a reaction product of pyromellitic dianhydride with 4,4′ -diaminodiphenyl ether and bis (3-aminopropyl) tetramethyldisiloxane and the like.

The polymer (a) is either a polymer derived only from repeating units of the above formula [1] or a copolymer or blend derived therefrom and other repeating units. In case of the latter copolymer or blend, the other repeating units may be selected from those which do not significantly degrate the heat resistance of the resulting polyimide.

As the compound (b) containing a radiation-dimerizable or radiation-polymerizable unsaturated bond and an amino group or a quarternary ammonium salt, there may be used a compound containing a olefine double bond and an amino group or a quarternarized amino group in molecule.

The following compounds [A], [B] or [C] or quarternary ammonium salts thereof may be mentioned as typical examples of the compound (b): 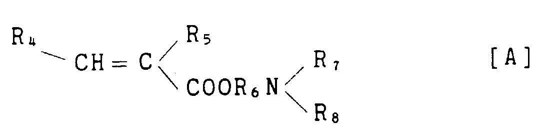 wherein R₄ is hydrogen or a phenyl group, R₅ is hydrogen or a alkyl group having 1 to 6 carbon atoms, R₆ is a substituted or unsubstituted hydrocarbon residue having 2 to 12 carbon atoms, and each of R₇ and R₈ is a substituted or unsubstituted alkyl group having 1 to 6 carbon atoms. 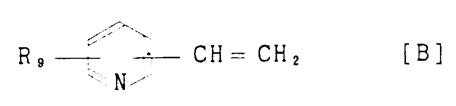 wherein R₉ is hydrogen, or a substituted or unsubstituted alkyl group having 1 to 6 carbon atoms. 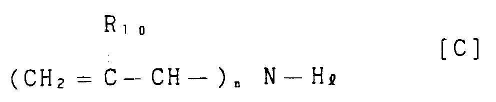 wherein R₁₀ is hydrogen or methyl group, n+ℓ=3, and n =an integer of 1 to 3.

Especially preferred examples of the compound (b) include

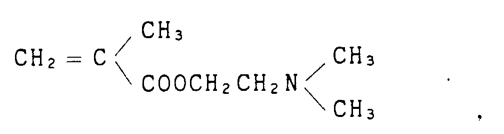

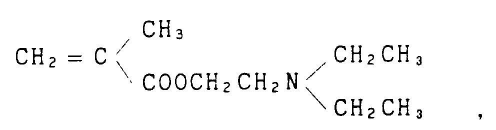

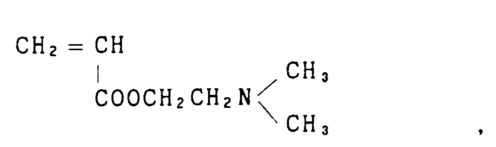

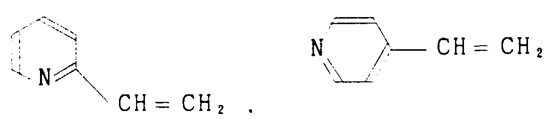

CH₂ = CH-CH₂NH₂,

and quarternary ammonium salts thereof.

From the view point of the photosensitivity, amino compounds having acryl group or methacryl group as the unsaturated group are preferred.

In the case of a compound (b) having an amino group and an unsaturated bond, it is desirable to combine the compound (b) with a polymer (a) in which R₃ of the repeating units [1] is hydrogen. In the case of a compound (b) having a quarternary ammonium salt and an unsaturated bond, it is desirable to combine the compound (b) with a polymer (a) in which R₃ of the repeating units [1] is an alkali metal ion or ammonium ion.

The compound (b) is preferably mixed with the polymer (a) in an amount of at least 0.05, more preferably at least 0.3 equivalent and less than 2 equivalents to the total carboxyl groups present in the polymer (a) .

The non-alicyclic organic compound (c) having a boiling point not lower than 120°C, containing at least one functional linkage selected from the group consisting of ester, ether and ketone linkages, and containing neither amino group nor hydroxyl group, used in the present invention, remains suitably in the resulting film even after the completion of prebaking, is superior in the compatibility with the polyimide precursor, acts as a plasticizer for the rigid polyimide precursor, and functions to improve the solubility in a developer. In order to remain in the film after the completion of prebaking, the non-alicylic compound (c) is necessary that the boiling point thereof be not lower than 120°C, preferably higher than 150°C. It is preferable that the non-alicyclic organic compound be volatilized to the exterior of the film in the final heating step for conversion of the polyimide precursor into polyimide after development, and that therefore the boiling point thereof be not higher than 400°C. In order to enhance the compatibility with the radiation-sensitive polyimide precursor, it is necessary for the non-alicyclic organic compound to have group of high polarity selected from ester, ether and ketone groups. On the other hand, the presence of hydroxyl and amino groups of high hydroscopicity is not desirable because cracking may result if development is conducted after a film of the radiation-sensitive polyimide precursor is allowed to stand.

The non-alicyclic organic compounds [3] are represented by the following general formula: 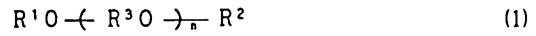 wherein R¹ and R² each represent R⁴CO or R⁴ where R⁴ is an alkyl group having 1 to 6 carbon atoms, an alkenyl group having 1 to 6 carbon atoms, an aryl group such as phenyl, or an aralkyl group such as benzyl, n is an integer of 1 to 3, and R³ is an alkylene group having 2 to 4 carbon atoms

Compounds of the above general formula (1), particularly those wherein R³ is ethylene, n is an integer of 1 to 3 and R⁴ is C₁₋₆ alkyl or C₁₋₆ alkylcarbonyl, are preferred.

Examples of the non-alicyclic organic compounds include ethylene glycol diacetate, ethylene glycol dipropionate, ethylene glycol acetate propionate, ethylene glycol diacrylate, ethylene glycol dimethacrylate, ethylene glycol dihexylate, ethylene glycol dibutylate, ethylene glycol dibenzoate, diethylene glycol diacetate, triethylene glycol diacetate, ethylene glycol diethyl ether, ethylene glycol dibenzyl ether, ethylene glycol dibutyl ether, ethylene glycol ethyl ether acetate, propylene glycol dimethyl ether, propylene glycol monomethyl ether acetate, dipropylene glycol methyl ether acetate, propylene glycol diacetate, ethoxy ethyl acetate,.

Among the non-alicyclic organic compounds described above, particularly preferred are ethylene glycol derivatives, propylene glycol derivatives, dipropylene glycol derivatives, diethylene glycol derivatives and triethylene glycol derivatives. Examples are ethylene glycol diacetate, ethylene glycol dipropionate, ethylene glycol acetate propionate, ethylene glycol diethly ether, ethylene glycol dibenzyl ether, ethylene glycol dibutyl ether, ethylene glycol ethyl ether acetate, diethylene glycol diacetate, triethylene glycol diacetate, propylene glycol dimethyl ether, propylene glycol monomethyl ether acetate, dipropylene glycol methyl ether acetate, and propylene glycol diacetate.

It is preferable that the non-alicyclic organic compound [3] be used in an amount of 2 to 150 wt%, more preferably 5 to 100 wt%, relative to the polymer (a).

Outside the above range, the developability is apt to be deteriorated and the development time may become longer or the image holding time shorter.

The sensitizer [4] is not specially limited. There may be used any conventional sensitizer for photocurable resins. Examples are benzophenone, acetophenone, anthrone, Michler's ketone, 4,4′ - bis (diethylamino) benzophenone, 2-nitrofluorene, 5-nitroacenaphthene, benzanthrone, N-acetyl-4-nitroaniline, dibenzalacetone, 2-t-butylanthraquinone, 1,2-benzanthraquinone, benzyl, N-acetyl-4-nitro-1-naphthylamine, 1-phenyl-1,2-butanedione-2-(o-methoxycarbonyl)oxime, 1-phenylpropanedione)-2-(o-ethoxycarbonyl)oxime, 1-phenyl-propanedione)-2-(o-benzoyl)oxime, 1-phenyl-5-mercapto-1H-tetrazole, 2-mercaptobenzimidazole, 2-mercaptothiazoline, 2-amino-5-mercapto-1,3,4-thiadiazole, 2-mercaptobenzoxazole, 4,4′ -bis-(dimethylamino)chalcone, 2,6-bis(4′ - diethylaminobenzal)-4-methylcyclohexanone, p-dimethylaminobenzylidene-indanone, triphenylphosphine, camphorquinone, carbon tetrabromide, N-phenyldiethanolamine, N-phenylethanolamine, 7-diethylamino-4-methylcoumarin, 7-diethylamino-3-benzoylcoumarin, 3,3′ -carbonyl-bis-(7-diethylaminocoumarin), N-phenylglycine, 2,6-bis-(4-azidobenzalcyclohexanone, diethylthioxanthone, benzoinisobutyl ether, 4-azidobenzalacetophenone, 3,3′ ,4,4′ - tetra(t-butylperoxycarbonyl)benzophenone, α , α-dimethoxy-α-phenylacetophenone, triphenylsulfonium salt, iron allene complex, phenylisoxazolone, 4-morpholino-benzophenone, benzyl ketal, 3-ethylamino-p-cresol, N-phenylmorpholine, 2-azidoanthraquinone, 4-azidobenzoic acid, 2-azido-5-nitroanisole, and 3-sulfonylazidobenzoic acid. These may be used each alone or as mixtures of two or more.

It is preferable that the sensitizer exemplified above be used in an amount of 0.1 to 20 wt% based on the weight of the polymer (a). An amount thereof outside this range cause deterioration of sensitivity and also in mechanical characteristics of the polyimide film.

An example of a manufacturing process for the composition of the present invention will now be described. First, a diamine compound and an acid dianhydride are reacted together in a solvent to prepare a polymer containing the structural unit [1]. Then, the compounds [2], [3] and [4], as well as other additives if required, are dissolved in the reaction solution to obtain the composition of the present invention. As the above polymer, a solid polyamide-acid polymer or the polymer separated and purified from the reaction solution may be used after redissolving.

As the solvent used in the above preparation process, a polar solvent is preferred from the standpoint of solubility of the polymer. Particularly, a non-protonic polar solvent is suitable. Preferred examples of non-protonic polar solvents include N-methyl-2-pyrrolidone, N,N-dimethylformamide, N,N-dimethylacetamide, dimethyl sulfoxide, hexametylphosphorotriamide, and γ-butyrolactone. As other additives, the composition may further contain a sensitizer, a comonomer and a material for improving the bonding with a substrate in range of not greatly deteriorating the sensitivity and heat resistance.

How to use the composition of the present invention will now be described. The composition of the present invention can be subjected to patterning according to a known fine pattern processing technique using actinic radiation.

First, the composition of the present invention is applied onto a suitable substrate. As the application method there may be adopted any of spin coating using a spinner, spray coating using a spray coater, immersion coating, printing, and roll coating. The coating thickness can be adjusted by changing application means or the solids content or viscosity of the composition.

As the material of the substrate onto which is applied the composition of the present invention, there may be used, for example, metal, glass, semiconductor, metal oxide insulator, or silicon nitride.

A suitable adhesion promotor may be used for improving the adhesion between the coating of the composition of the present invention or the polyimide film after heat treatment and the substrate.

Preferred examples of adhesion promotors include organosilicon compounds such as hydroxypropyltrimethoxysilane, γ-glycidoxypropyltrimethoxysilane, γ-aminopropyltriethoxysilane and γ-methacryloxypropyltrimethoxysilane; aluminum chelate compounds such as aluminum monoethylacetoacetate diisopropylate and aluminum tris (acetylacetonate); and titanium chelate compounds such as titanium bis (acetylacetonate).

The film thus formed on the substrate using the composition of the present invention is then exposed to actinic radiation in the form of a desired pattern. As examples of actinic radiation there are mentioned X-rays, electron beams, ultraviolet rays and visible rays. Particularly, ultraviolet rays and visible rays of short wave lengths ranging from 200 to 500 nm are preferred.

Then, unradiated portion is removed by dissolving in developer to obtain a relief pattern. A suitable developer may be used according to the structure of the polymer used. For example, as the developer, N-methyl-2-pyrrolidone, N-acetyl-2-pyrrolidone, N,N-dimethylformamide, N,N-dimethylacetamide, dimethyl sulfoxide, or hexamethylphosphorotriamide, which are solvents employable for the composition of the present invention, may be used alone or as a mixture thereof with a non-solvent for the composition such as, methanol, ethanol, isopropyl alcohol, water, methyl carbitol, ethyl carbitol, toluene, or xylene. Further, aqueous ammonia and other aqueous alkaline solutions are employable in many cases.

The development can be performed, for example, by spraying a developer onto the surface of the coated film, or dipping the film in the developer optionally under ultrasonic agitation.

It is desirable that the relief pattern formed by the development be subsequently rinsed with a rinsing liquid. Preferred examples of the rinsing liquid are methanol, ethanol, isopropyl alcohol and butyl acetate which are highly miscible with the developer.

The polymer of the relief pattern obtained by the above treatment is a polyimide polymer precursor having heat resistance, which upon heat treatment affords a heat-resistant polymer having an imide ring or another cyclic structure. Usually, the heat treatment is performed while the temperature is raised stepwise or continuously in the range of 135°C to 400°C.

The radiation-sensitive polymer composition of the present invention is used for the formation of a semiconductor passivation film, a passivation buffer coating film, an inter-layer insulating film for a multi-layer integrated circuit, an inter-layer insulating film or a surface protecting film for a hybrid integrated circuit, a soldering protective film for a printed circuit, an orientation-controlling film for a liquid crystal display device, and an inter-layer insulating film for a packaging substrate. Also, as a photoresist of high heat resistance, the composition of the invention is applicable to the deposition of metal and a dry etching process. Further, the composition is applicable to the known uses of polyimides.

The radiation-sensitive composition of the present invention can greatly improve the developability and can afford a polyimide film superior in mechanical properties such as strength and elongation.

Mechanical properties of the composition of the present invention were measured in the following manner.

A photosensitive polyimide precursor solution was applied by spin coating onto a polyethylene terephthalate film having a thickness of 125 µm to form a photosensitive polyimide film, followed by drying at 80°C to volatilize the solvent. The photosensitive polyimide film was separated from the polyethylene terephthalate film, then fixed to an iron plate and heat-treated at 200°C, 300°C and 350°C each for 30 minutes in a nitrogen atmosphere to obtain a polyimide film 25µ in thickness. This film was measured for strength and elongation according to ASTM-D882-64T.

### [Examples]

The following examples are given to illustrate the present invention more concretely, but the invention is not limited thereto.

### Example 1

207.6 g of 4,4' -diaminodiphenyl sulfide and 9.94 g of tetramethyldisiloxane were dissolved in 1,530 g of N-methyl-2-pyrrolidone to prepare an amine solution. 213.76 g of pyromellitic anhydride was added to this amine solution and reaction was allpwed to take place at 50°C for 3 hours to prepare a polymer solution (A) having a viscosity of 13 Pa.s (130 poise) at 25 °C.
The polymer solution (A) was mixed with 370 g of diethylaminoethyl methacrylate. Then, a solution of 17.25 g 4-azidobenzalacetophenone and 8.12 g N-phenyldiethanolamine in 250 g N-methyl-2-pyrrolidone, as well as 260 g (60.3 wt% based on the weight of the polymer) of ethylene glycol diacetate (b.p. 189°C ), were incorporated in the mixture prepared above, and the resultant mixture was filtered.

The solution thus obtained was spin-coated on a silicon wafer by a spinner and then dried at 90°C and 95°C each for 3 minutes, using a vacuum chuck type hot plate (SCW 636, a product of Dainippon Screen Mfg. Co., Ltd.). The thickness of the film thereby obtained was 10 µm. The film was set to an exposure unit (PLA-501F, a product of Canon Inc.) and exposure was performed using ultraviolet rays through a test pattern for 10 seconds. The ultraviolet ray intensity was 8 mW/cm² (365 nm). Thereafter, an immersion development was performed using a mixed solvent of N-methylpyrrolidone (70 parts) and xylene (30 parts). The dissolving time of unexposed area was 30 seconds. The development was stopped in 45 seconds, following by rinsing with isopropanol for 20 seconds and subsequent spin-drying using a spinner. The film thickness after the development was found to be 8.0 µ m (reduction in film thickness: 2.0 µ m). Thereafter, the film was heat-treated at 200°C and 350°C each for 30 minutes and then the pattern was observed using an optical microscope to find that there was resolved 20µm line and space.

The film formed from the foregoing polyimide precursor solution proved to have a strength of 11 kg/mm² and an elongation of 25%, thus exhibited good characteristics.

### Example 2 (not according claim 1)

192.2 g of 4,4' -diaminodiphenyl ether and 9.49 g of 1,3-bis (3-aminopropyl) tetramethyldisiloxane were dissolved in 1,890 g of N-methyl-2-pyrrolidone to prepare an amine solution. To this amine solution was added 315.7 g of benzophenonetetracarboxylic anhydride and reaction was allowed to take place at 50°C for 3 hours to obtain a polymer solution (B) having a viscosity of 15 Pa.s (150 poise) at 25°C. The polymer solution (B) was obtained.

### Example 3

207.6 g of 4,4' -diaminodiphenyl sulfide and 9.94 g of 1,3-bis(3-aminopropyl) tetramethyl-disoloxane were dissolved in 1,890 g of N-methly-2-pyrrolidone to prepare an amine solution. To this amine solution was added 315.7 g of 3,3' ,4,4 '-benzophenonetetracarboxylic anhydride and reaction was allowed to take place at 50 °C for 3 hours to obtain a polymer solution (C) having a viscosity of 13 Pa.s (130 poise) at 25 °C. The polymer solution (C) was mixed with 370 g of diethylaminoethyl methacrylate. Then, a solution of 10.3 g N-phenyldiethanolamine, 20.6 g 4-azidobenzalacetophenone and 20.6 g N-phenylglycine in 300 g N-methyl-2-pyrrolidone, as well as 260 g (48.8 wt% based on the weight of the polymer) of ethylene glycol diacetate (b.p. 189°C), were incorporated in the mixture prepared above and the resultant mixture was filtered.

The solution thus obtained was spin-coated on a silicon wafer by a spinner and then dried at 90°C and 95°C each for 3 minutes, using a vacuum chuck type hot plate (SCW 636, a product of Dainippon Screen Mfg. Co., Ltd.).
The thickness of the film thereby obtained was 10 µm. The film was set to an exposure unit (PLA-501F, a product of Canon Inc.) and exposure was performed using ultraviolet rays through a test pattern for 10 seconds. The ultraviolet ray intensity was 8 mW/cm² (365 nm). Thereafter, an immersion development was performed using a mixed solvent of N-methylpyrrolidone (70 parts) and methanol (30 parts). The dissolving time of unexposed area was 30 seconds. The development was stopped in 45 seconds, followed by rinsing with isopropanol for 20 seconds and subsequent spin-drying using a spinner. The film thickness after the development was found to be 8.5 µ m (reduction in film thickness: 1 .5µ m ). Thereafter, the film was heat-treated at 200°C and 350°C each for 30 minutes and then the pattern was observed using an optical microscope to find that was resolved 20µm line and space.

The film formed from the foregoing polyimide precursor solution proved to have a strength of 12kg/mm² and an elongation of 18%, thus exhibited good characteristics.

### Example 4

The same polymer solution (A) as that used in Example 1 was mixed with 370 g of diethylaminoethyl methacrylate. Then, a solution of 17.25 g 4-azidobenzalacetophenone and 8.12 g N-phenyldiethanolamine in 250 g N-methyl-2-pyrrolidone, as well as 260g (60.3 wt% based on the weight of the polymer) of dipropylene glycol monomethyl ether acetate (b.p. 209 °C ), were incorporated in the mixture prepared above and the resultant mixture was filtered.

The solution thus obtained was spin-coated on silicon wafer by a spinner and then dried at 90°C and 95°C each for 3 minutes, using a vacuum chuck type hot plate (SCW 636, a product of Dainippon Screen Mfg. Co., Ltd.). The thickness of the film thereby obtained was 10 µ m. The film was set to an exposure unit (PLA-501F, a product of Canon Inc.) and exposure was conducted using ultraviolet rays through a test pattern for 10 seconds. The ultraviolet ray intensity was 8 mW/cm² (365 nm). Thereafter, an immersion development was performed using a mixed solvent of N-methylpyrrolidone (70 parts) and xylene (30 parts). The dissolving time of unexposed area was 40 seconds. The development was stopped in 60 seconds, followed by rinsing with isopropanol for 20 seconds and subsequent spin-drying using a spinner. The film thickness after the development was found to be 7.5 µ m (reduction in film thickness: 2.5 µm ). Then, the film was heat-treated at 200°C and 350 °C each for 30 minutes and then the pattern was observed using an optical microscope to find that there was resolved 20 µm line and space.

The film formed from the foregoing polyimide precursor solution proved to have a strength of 11 kg/mm² and an elongation of 25%, thus exhibited good characteristics.

### Comparative Example 1

The same polymer solution (A) as that used in Example 1 was mixed with 370 g of diethylaminoethyl methacrylate. Then, a solution of 10.3 g N-phenyldiethanolamine and 20.6 g 4-azidobenzalacetophenone in 300 g N-methyl-2-pyrrolidone was incorporated in the mixture prepared above and the resultant mixture was filtered.

The solution thus obtained was spin-coated on a silicon wafer by a spinner and then dried at 90°C and 95°C each for 3 minutes, using a vacuum chuck type hot plate (SCW 636, a product of Dainippon Screen Mfg. Co., Ltd.). The thickness of the film thus formed was 10 µ m. The film was set to an exposure unit (PLA-501F, a product of Canon Inc. ) and exposure was conducted using ultraviolet rays through a test pattern for 10 seconds. The ultraviolet ray intensity was 8 mW/cm² (365 nm). Thereafter, an immersion development was perfoemed using a mixed solvent of N-methylpyrrolidone (70 parts) and xylene (30 parts). The dissolving time of unexposed area was 1 minute and 30 seconds. The development was stopped in 2 minutes, following by rinsing with isopropanol for 20 seconds and subsequent spin-drying using a spinner. The film thickness after the development was found to be 7.5 µ m (reduction in film thickness: 2.5 µ m). Thereafter, the film was heat-treated at 200°C and 350°C each for 30 minutes and the pattern was observed using an optical microscope to find that the film somewhat remained also in 40µm line and space.

### Comparative Example 2

The polymer solution (B) used in Example 2 was mixed with 370 g of diethylaminoethyl methacrylate, and the resultant mixture was further mixed with a solution of 20.6 g Michler's ketone in 250 g N-methyl-2-pyrrolidone. The mixture thus prepared was filtered.

The solution thereby obtained was spin-coated on a silicon wafer by a spinner and then dried at 80°C for 1 hour to form a film having a thickness of 10 µ m. Then, the film was subjected to exposure under the same conditions as in Example 2. Subsequently, an immersion development was performed using a mixed solvent of N-methylpyrrolidone (70 parts) and methanol (30 parts). The dissolving time of unexposed area was 2 minutes. The development was stopped in 2 minutes and 30 seconds, followed by rinsing with isopropanol for 20 seconds and subsequent spin-drying using a spinner. The film thickness after the development was found to be 7.8 µm (reduction in film thickness: 2.2 µm).
Thereafter, the film was heat-treated at 200°C and 350°C each for 30 minutes and then the pattern was observed using an optical microscope to find that the film somewhat remained also in 40µm line and space.

### Comparative Example 3

192.2 g of 4,4' -diaminodiphenyl ether and 9.94 g of 1,3-bis (3-aminopropyl)tetramethyldisiloxane were dissolved in 150 g of N-methyl-2-pyrrolidone to prepare an amine solution.
To this amine solution was added 273.9 g of 3,3' ,4,4' -benzophenonetetracarboxylic anhydride and reactionwas allowed to take place at 50°C for 3 hours to obtain a polymer solution (D) having a viscosity of 20 Pa.s (200 poise) at 25°C.
The polymer solution (D) was mixed with 370 g of diethylaminoethyl methacrylate, and this mixture was further mixed with a solution of 8.63 g Michler's ketone in 350 g N-methyl-2-pyrrolidone. The resultant mixture was filtered.

The solution thus obtained was spin-coated on a silicon wafer by a spinner and then dried at 80°C for 1 hour to form a film having a thickness of 10µm. The film was set to the foregoing exposure unit and exposed through a test pattern, using ultraviolet rays, for 30 seconds. The ultraviolet ray intensity was 8 mW/ cm² (365 nm). Thereafter, an immersion development was conducted using a mixed solvent of N-methylpyrrolidone (70 parts) and xylene (30 parts). The dissolving time of unexposed area was 40 seconds. The development was stopped in 1 minute, followed by rinsing with isopropanol for 20 seconds and subsequent spin-drying with a spinner. The film thickness after the development was 8.5 µ m (reduction in film thickness: 1.5 µ m). Then, the film was heat-treated at 200°C and 350°C each for 30 minutes and the pattern was observed using an optical microscope to find that there was resolved 20µm line and space. However, when the film formed from the foregoing polyimide precursor solution was measured for characteristics, the strength and elongation thereof were 8kg/mm² and 5%, respectively, and thus extremely inferior.

### Comparative Example 4

The polymer solution (A) used in Example 1 was mixed with 370 g of diethylaminoethyl acrylate, then a solution of 17.25 g 4-azidobenzalacetophenone and 8.12 g N-phenyldiethanolamine in 250 g N-methyl-2-pyrrolidonne, as well as 260 g (60.3 wt% based on the polymer) of ethylene glycol (b.p. 197.7°C ), were incorporated in the mixture just prepared, and the resultant solution was filtered.

The solution thus obtained was spin-coated on a silicon wafer by a spinner and then dried at 90°C and 95°C each for 3 minutes, using a vacuum chuck type hot plate (SCW 636, a product of Dainippon Screen Mfg. Co., Ltd.), to obtain a film 10 µ m in thickness. The film was set to an exposure unit (PLA-501F, a product of Canon Inc.) and exposure was conducted using ultraviolet rays through a test pattern for 10 seconds. The ultraviolet ray intensity of 8 mW/cm². Thereafter, an immersion development was conducted using a mixed solvent of N-methylpyrrolidone (70 parts) and xylene (30 parts). The dissolving time of unexposed area was 10 seconds, but the image dissolved in 5 seconds thereafter.

## Claims

1. A radiation-sensitive polymer composition comprising:
(a) a polymer containing repeating units [1] represented by the general formula 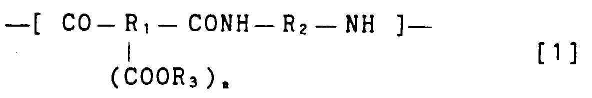 wherin R₁ is a trivalent or tetravalent organic residue having at least two carbon atoms, R2 is a divalent organic residue having at least two carbon atoms, R₃ is hydrogen or an alkali metal counter ion, and n is 1 or 2;
(b) a compound containing a radiation-dimerizable or radiation-polymerizable unsaturated bond and an amino group or a quaternary ammonium salt;
(c) a non-alicyclic organic compound, having a boiling point not lower than 120°C, represented by the general formula 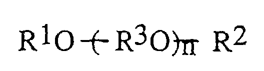 wherein R¹ and R² each represent R⁴CO or R⁴, R⁴ is an alkyl group having 1 to 6 carbon atoms, an alkenyl group having 1 to 6 carbon atoms, an aryl group or an aralkyl group, n is an integer of 1 to 3, and R³ is an alkylene group having 2 to 4 carbon atoms; and
(d) optionally a sensitizer.

2. A composition as set forth in claim 1, wherein in formula [1] R₁ is a trivalent or tetravalent aromatic or heteroaromatic residue having 6 to 30 carbon atoms, R₂ is a divalent aromatic or heteroaromatic residue having 6 to 30 carbon atoms.

3. A composition as set forth in claim 1, wherein "n" in the formula [ I ] is 2 and each COOR₃ is located in an ortho position with respect to the amide linkage in the main chain or the polymer.

4. A composition as set forth in claim 1, wherein in formula [1] R₁ is an aromatic residue of a formula selected from the group consisting of 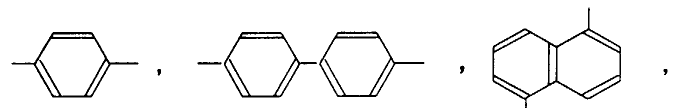 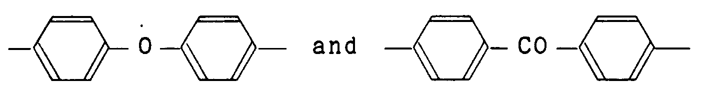 wherein each of the divalent bonds is a bond constituting an amide linkage of the main chain of the polymer (a) and the group COOR₃ attached to R₁ is located at an ortho-position with respect to the above bonding.

5. A composition as set forth in claim 1, wherein in formula [1] R₁ is an aromatic residue of a formula selected from the group consisting of

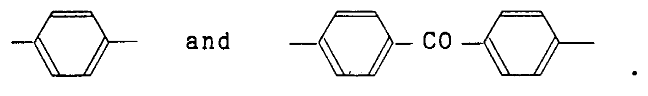

6. A composition as set forth in claim 1, wherein the polymer (a) contains at least two kinds of R₁ groups.

7. A composition as set forth in claim 1, wherein in formula [1] R₂ is an aromatic residue of a formula selected from the group consisting of 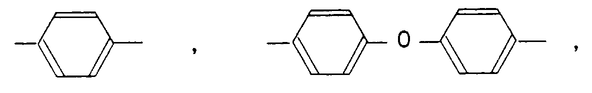 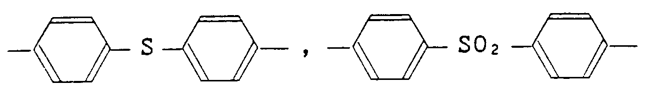 and 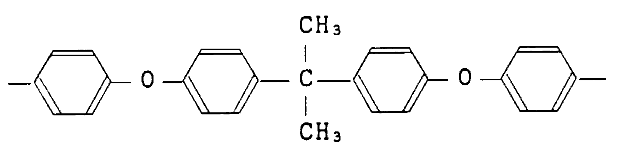 wherein each of the divalent bonds is a bond constituting an amide linkage of the main chain of the polymer (a).

8. A composition as set forth in claim 1, wherein the polymer (a) contains at least two kinds of R₂ groups.

9. A composition as set forth in claim 1, wherein the compound (b) is at least one compound represented by the general formula: 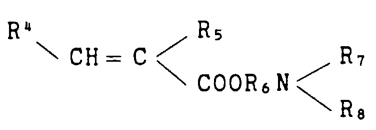 wherein R₄ is hydrogen or a phenyl group, R₅ is hydrogen or an alkyl group having 1 to 6 carbon atoms, R₆ is a substituted or unsubstituted hydrocarbon residue having 2 to 12 carbon atoms, and each of R₇ and R₈ is a substituted or unsubstituted alkyl group having 1 to 6 carbon atoms, or a quarternary ammonium salt thereof.

10. A composition as set forth in claim 1, wherein the compound (b) is at least one compound represented by the general formula 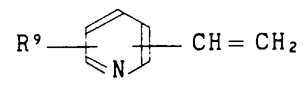 wherein R₉ is hydrogen, or a substituted or unsubstituted alkyl group having 1 to 6 carbon atoms, or a quarternary ammonium salt thereof.

11. A composition as set forth in claim 1, wherein the compound (b) is at least one compound represented by the general formula 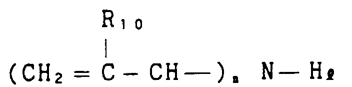 wherein R₁₀ is hydrogen or methyl group, n+ ℓ is 3 and n is an integer of 1 to 3, a quarternary ammonium salt thereof.

12. A composition as set forth in claim 1, wherein the compound (b) is a compound selected from the group consisting of 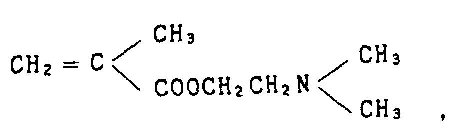 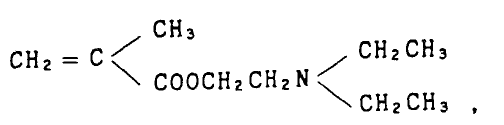 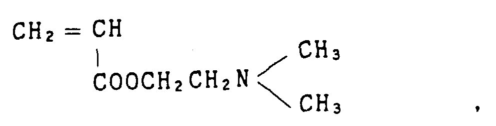 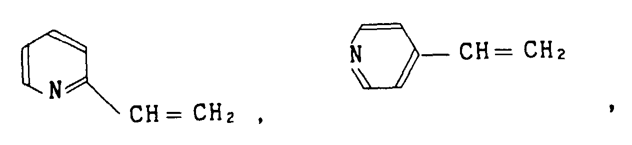
CH₂ = CH-CH₂NH₂
and quarternary ammonium salts thereof.

13. A composition as set forth in claim 1, wherein the amount of the compound (b) is at least 0.05 equivalent to the total carboxyl groups present in the polymer (a).

14. A composition as set forth in claim 13, wherein the amount of the compound (b) is in the range of 0.3 to 2 equivalent to the total carboxyl groups present in the polymer(a).

15. A composition as set forth in claim 1, wherein in compound (c) R³ is ethylene, n is an integer of 1 to 3 and R⁴ is an alkyl group having 1 to 6 carbon atoms or an alkylcarbonyl group having 1 to 6 carbon atoms.

16. A composition as set forth in claim 1, wherein the non-alicyclic organic compound (c) is selected from the group consisting of ethylene glycol derivatives, propylene glycol derivatives, dipropylene glycol derivatives, diethylene glycol derivatives and triethylene glycol derivatives.

17. A composition as set forth in claim 1, wherein the non-alicyclic organic compound (c) is ethylene glycol diacetate, ethylene glycol dipropionate, ethylene glycol acetate propionate, ethylene glycol diethyl ether, ethylene glycol dibenzyl ether, ethylene glycol dibutyl ether, ethylene glycol ethyl ether acetate, diethylene glycol diacetate, triethylene glycol diacetate, propylene glycol dimethyl ether, propylene glycol monomethyl ether acetate, dipropylene glycol methyl ether acetate, or propylene glycol diacetate.

18. A composition as set forth in claim 1, wherein the amount of the non-alicyclic organic compound (c) is 2 to 150% by weight of the polymer (a).

19. A composition as set forth in claim 1, wherein the amount of the sensitizer is 2 to 150% by weight of the polymer (a).

## Patentansprüche

1. Strahlungsempfindliche Polymerzusammensetzung, welche umfaßt:
(a) ein Polymer mit sich wiederholenden Einheiten der allgemeinen Formel [1] 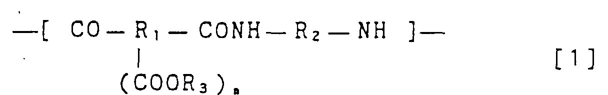 worin R₁ ein dreiwertiger oder vierwertiger organischer Rest mit mindestens zwei Kohlenstoffatomen ist,
R₂ ein zweiwertiger organischer Rest mit mindestens zwei Kohlenstoffatomen ist, R₃ Wasserstoff oder ein Alkalimetall-Gegenion ist, und n 1 oder 2 ist;
(b) eine Verbindung, die eine durch Strahlung dimerisierbare oder durch Strahlung polymerisierbare ungesättigte Bindung und eine Aminogruppe oder ein quaternäres Ammoniumsalz enthält;
(c) eine nichtalicyclische organische Verbindung mit einem Siedepunkt von nicht weniger als 120°C, die durch die allgemeine Formel
R¹O(̵R³O)̵ₙ R²
dargestellt wird, worin R¹ und R² jeweils R⁴CO oder R⁴ darstellen, R⁴ eine Alkylgruppe mit 1 bis 6 Kohlenstoffatomen, eine Alkenylgruppe mit 1 bis 6 Kohlenstoffatomen, eine Arylgruppe oder eine Aralkylgruppe ist, n eine ganze Zahl von 1 bis 3 ist und R³ eine Alkylengruppe mit 2 bis 4 Kohlenstoffatomen ist; und
(d) wahlfrei ein Sensibilisierungsmittel.

2. Zusammensetzung nach Anspruch 1, wobei in der Formel [1] R₁ ein dreiwertiger oder vierwertiger aromatischer oder heteroaromatischer Rest mit 6 bis 30 Kohlenstoffatomen ist, R₂ ein zweiwertiger aromatischer oder heteroaromatischer Rest mit 6 bis 30 Kohlenstoffatomen ist.

3. Zusammensetzung nach Anspruch 1, wobei "n" in der Formel [1] 2 beträgt und jedes COOR₃ in ortho-Position bezüglich der Amidbindung in der Hauptkette oder dem Polymer angeordnet ist.

4. Zusammensetzung nach Anspruch 1, wobei R₁ in der Formel [1] ein aromatischer Rest der Formel ist, der aus der Gruppe ausgewählt ist, die aus 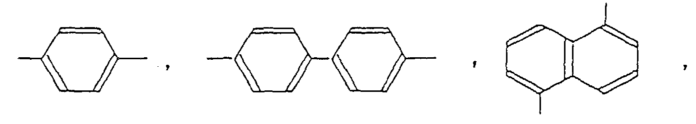 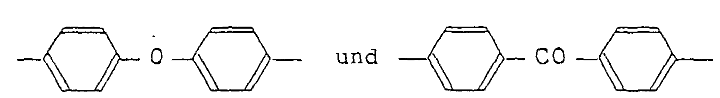 besteht, wobei jede zweiwertige Bindung eine Bindung ist, die aus der Amidbindung der Hauptkette des Polymers (a) besteht, und die Gruppe COOR₃, die mit R₁ gebunden ist, in der ortho-Position bezüglich der obengenannten Bindung angeordnet ist.

5. Zusammensetzung nach Anspruch 1, wobei R₁ in der Formel [1] ein aromatischer Rest der Formel ist, die aus der Gruppe ausgewählt ist, die aus 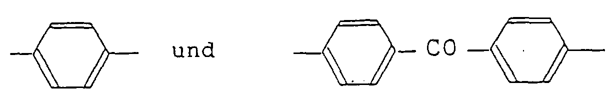 besteht.

6. Zusammensetzung nach Anspruch 1, wobei das Polymer (a) mindestens zwei Arten von R₁-Gruppen enthält.

7. Zusammensetzung nach Anspruch 1, wobei R₂ in der Formel [1] ein aromatischer Rest der Formel ist, die aus der Gruppe ausgewählt ist, die aus 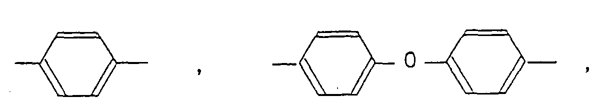 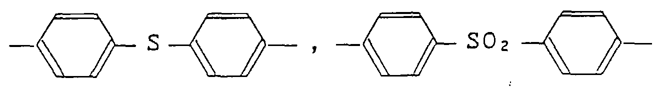 und 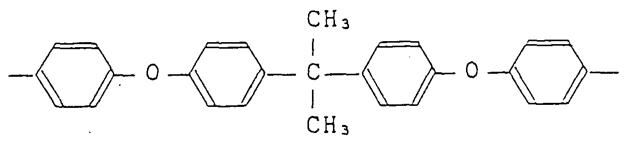 besteht, wobei jede zweiwertige Bindung eine Bindung ist, die die Amidbindung der Hauptkette des Polymers (a) bildet.

8. Zusammensetzung nach Anspruch 1, wobei das Polymer (a) mindestens zwei Arten von R₂-Gruppen enthält.

9. Zusammensetzung nach Anspruch 1, wobei die Verbindung (b) mindestens eine Verbindung ist, die durch die allgemeine Formel dargestellt wird: 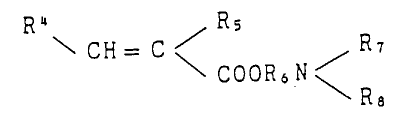 worin R₄ Wasserstoff oder eine Phenylgruppe ist, R₅ Wasserstoff oder eine Alkylgruppe mit 1 bis 6 Kohlenstoffatomen ist, R₆ ein substituierter oder unsubstituierter Kohlenwasserstoffrest mit 2 bis 12 Kohlenstoffatomen ist, und jedes R₇ und R₈ eine substituierte oder unsubstituierte Alkylgruppe mit 1 bis 6 Kohlenstoffatomen ist, oder ein quaternäres Ammoniumsalz davon.

10. Zusammensetzung nach Anspruch 1, wobei die Verbindung (b) mindestens eine Verbindung der allgemeinen Formel ist: 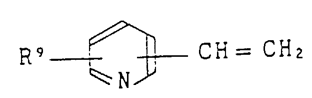 worin R₉ Wasserstoff oder eine substituierte oder unsubstituierte Alkylgruppe mit 1 bis 6 Kohlenstoffatomen ist, oder ein quaternäres Ammoniumsalz davon.

11. Zusammensetzung nach Anspruch 1, wobei die Verbindung (b) mindestens eine Verbindung der allgemeinen Formel ist: 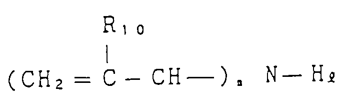 worin R₁₀ Wasserstoff oder eine Methylgruppe ist, n + 1=3 ist, und n eine ganze Zahl von 1 bis 3 ist, oder ein quaternäres Ammoniumsalz davon.

12. Zusammensetzung nach Anspruch 1, wobei die Verbindung (b) eine Verbindung ist, die aus der Gruppe ausgewählt ist, die aus 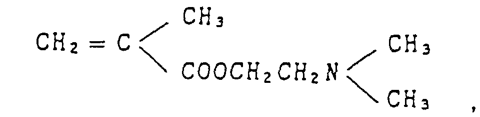 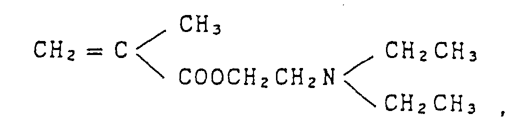 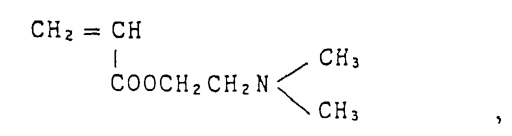 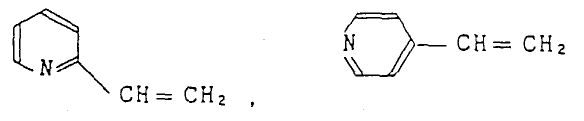
CH₂ = CH-CH₂NH₂
und quaternären Ammoniumsalzen davon besteht.

13. Zusammensetzung nach Anspruch 1, wobei die Menge der Verbindung (b) bezogen auf die gesamten im Polymer (a) vorhandenen Carboxylgruppen mindestens 0,05 Äquivalente beträgt.

14. Zusammensetzung nach Anspruch 13, wobei die Menge der Verbindung (b) bezogen auf die gesamten im Polymer (a) vorhandenen Carboxylgruppen im Bereich von 0,3 bis 2 Äquivalenten liegt.

15. Zusammensetzung nach Anspruch 1, wobei in der Verbindung (c) R³ Ethylen ist, n eine ganze Zahl von 1 bis 3 ist, und R⁴ eine Alkylgruppe mit 1 bis 6 Kohlenstoffatomen oder eine Alkylcarbonylgruppe mit 1 bis 6 Kohlenstoffatomen ist.

16. Zusammensetzung nach Anspruch 1, wobei die nichtalicyclische organische Verbindung (c) aus der Gruppe ausgewählt ist, die aus Ethylenglycol-Derivaten, Propylenglycol-Derivaten, Dipropylenglycol-Derivaten, Diethylenglycol-Derivaten und Triethylenglycol-Derivaten besteht.

17. Zusammensetzung nach Anspruch 1, wobei die nichtalicyclische organische Verbindung (c) Ethylenglycoldiacetat, Ethylenglycoldipropionat, Ethylenglycolacetatpropionat, Ethylenglycoldiethylether, Ethylenglycoldibenzylether, Ethylenglycoldibutylether, Ethylenglycolethyletheracetat, Diethylenglycoldiacetat, Triethylenglycoldiacetat, Propylenglycoldimethylether, Propylenglycolmonomethyletheracetat, Dipropylenglycolmethyletheracetat oder Propylenglycoldiacetat ist.

18. Zusammensetzung nach Anspruch 1, wobei die Menge der nichtalicyclischen organischen Verbindung (c) 2 bis 150 Gew.-% des Polymers (a) beträgt.

19. Zusammensetzung nach Anspruch 1, wobei die Menge des Sensibilisierungsmittels 2 bis 150 Gew.-% des Polymers (a) beträgt.

## Revendications

1. Composition polymérique sensible aux radiations comprenant :
(a) un polymère contenant des motifs répétés [1] représenté par la formule générale 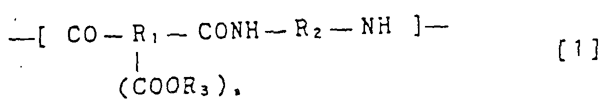 dans laquelle R₁ est un résidu organique trivalent ou tétravalent comportant au moins deux atomes de carbone, R₂ est un résidu organique divalent comportant au moins deux atomes de carbone, R₃ est un atome d'hydrogène ou un contre-ion métallique alcalin et n est 1 ou 2 ;
(b) un composé contenant une liaison insaturée dimérisable ou polymérisable par radiation et un groupe amino ou un sel d'ammonium quaternaire ;
(c) un composé organique non-alicyclique ayant un point d'ébullition non inférieur à 120°C, représenté par la formule générale 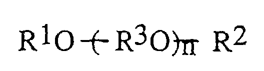 dans laquelle R¹ et R² représentent chacun R⁴CO ou R⁴, R⁴ est un groupe alkyle comportant 1 à 6 atomes de carbone, un groupe alcényle comportant 1 à 6 atomes de carbone, un groupe aryle ou un groupe aralkyle, n est un nombre entier de 1 à 3 et R³ est un groupe alcoylène comportant 2 à 4 atomes de carbone ; et
(d) facultativement un agent sensibilisant.

2. Composition selon la revendication 1, dans laquelle dans la formule [1] R₁ est un résidu aromatique trivalent, ou tétravalent, ou un résidu hétéroaromatique comportant 6 à 30 atomes de carbone, R₂ est un résidu aromatique divalent ou un résidu hétéroaromatique comportant 6 à 30 atomes de carbone.

3. Composition selon la revendication 1, dans laquelle "n" dans la formule [1] est 2 et chaque COOR₃ occupe une position ortho par rapport à l'assemblage d'amide dans la chaîne principale ou dans le polymère.

4. Composition selon la revendication 1, dans laquelle, dans la formule [1], R₁ est un résidu aromatique d'une formule choisie dans le groupe constitué de 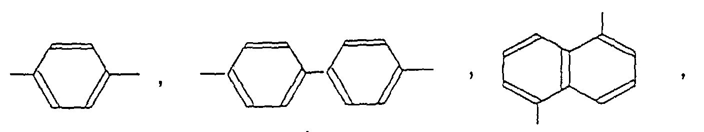 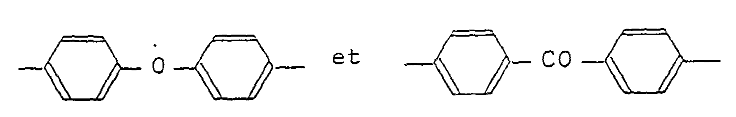 dans laquelle chacune des liaisons divalentes est une liaison constituant un assemblage d'amide de la chaîne principale du polymère (a) et le groupe COOR₃ lié à R₁ occupe une position ortho par rapport à la liaison ci-dessus.

5. Composition selon la revendication 1, dans laquelle dans la formule [1] R₁ est un résidu aromatique d'une formule choisie dans le groupe constitué de

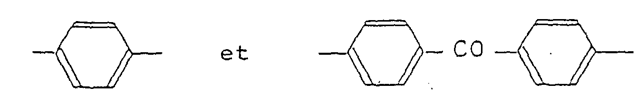

6. Composition selon la revendication 1, dans laquelle le polymère (a) contient au moins deux types de groupes R₁.

7. Composition selon la revendication 1, dans laquelle dans la formule [1], R₂ est un résidu aromatique d'une formule choisie dans le groupe constitué de 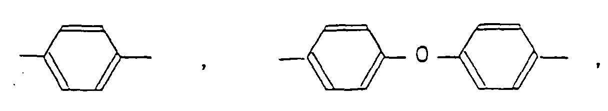 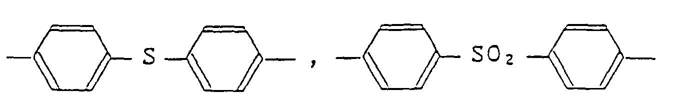 et 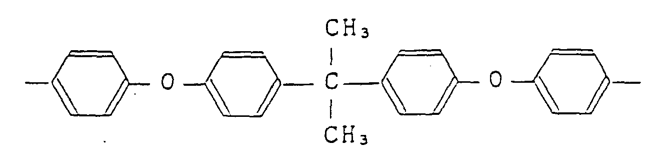 dans laquelle chacune des liaisons divalentes est une liaison constituant un assemblage d'amide de la chaîne principale du polymère (a).

8. Composition selon la revendication 1, dans laquelle le polymère (a) contient au moins deux types de groupes R₂.

9. Composition selon la revendication 1, dans laquelle le composé (b) est au moins un composé représenté par la formule générale : 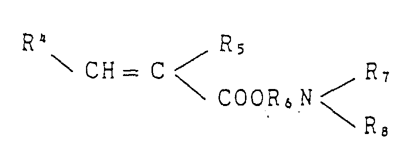 dans laquelle R₄ est un atome d'hydrogène ou un groupe phényle, R₅ est un atome d'hydrogène ou un groupe alkyle comportant 1 à 6 atomes de carbone, R₆ est un résidu hydrocarboné substitué ou non substitué comportant 2 à 12 atomes de carbone et chacun de R₇ et de R₈ est un groupe alkyle substitué ou non substitué comportant 1 à 6 atomes de carbone ou un sel d'ammonium quaternaire de ceux-ci.

10. Composition selon la revendication 1, dans laquelle le composé (b) est au moins un composé représenté par la formule générale : 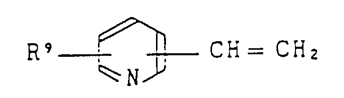 dans laquelle R₉ est un atome d'hydrogène ou un groupe alkyle substitué ou non substitué comportant 1 à 6 atomes de carbone ou un sel d'ammonium quaternaire de ceux-ci.

11. Composition selon la revendication 1, dans laquelle le composé (b) est au moins un composé représenté par la formule générale : 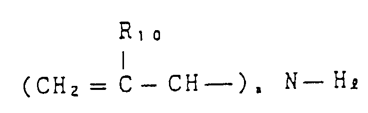 dans laquelle R₁₀ est un atome d'hydrogène ou un groupe méthyle, n+ℓ est 3 et n est un nombre entier de 1 à 3, un sel d'ammonium quaternaire de ceux-ci.

12. Composition selon la revendication 1, dans laquelle le composé (b) est un composé choisi dans le groupe constitué de 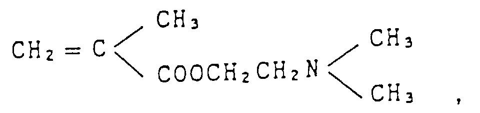 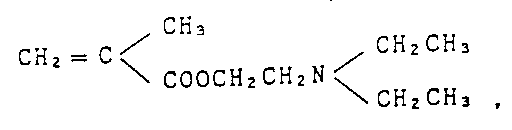 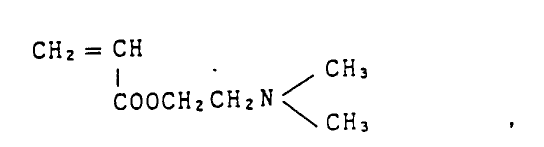 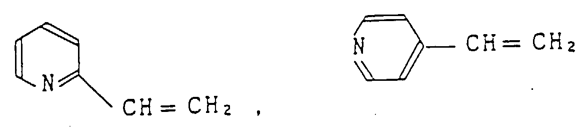
CH₂ = CH-CH₂NH₂
et des sels d'ammonium quaternaire de ceux-ci.

13. Composition selon la revendication 1, dans laquelle la quantité du composé (b) est au moins 0,05 équivalent des groupes carboxyle totaux présents dans le polymère (a).

14. Composition selon la revendication 13, dans laquelle la quantité du composé (b) est comprise dans la plage de 0,3 à 2 équivalent des groupes carboxyle totaux présents dans le polymère (a).

15. Composition selon la revendication 1, dans laquelle R³ est l'éthylène, n est un nombre entier de 1 à 3 et R⁴ est un groupe alkyle comportant 1 à 6 atomes de carbone ou un groupe alkylcarbonyle comportant 1 à 6 atomes de carbone.

16. Composition selon la revendication 1, dans laquelle le composé organique non-alicyclique (c) est choisi dans le groupe constitué de dérivés de l'éthylène glycol, de dérivés du propylène glycol, de dérivés du dipropylène glycol, de dérivés du diéthylène glycol et de dérivés du triéthylène glycol.

17. Composition selon la revendication 1, dans laquelle le composé organique non-alicyclique (c) est le diacétate d'éthane-1,2-diyle,
le dipropionate d'éthane-1,2-diyle, le propionate et l'acétate d'éthane-1,2-diyle, le 1,2-diéthoxyéthane, le 1,2-dibenzoxyéthane, le 1,2-dibutoxyéthane,
l'acétate de 2-éthoxyéthane-1-yle,
le diacétate de 3-oxapentane-1,5-diyle,
le diacétate de 3,6-dioxaoctane-1,8-diyle,
le 1,3-diméthoxypropane, l'acétate de 3-méthoxypropane-1-yle, l'acétate de 4,8-oxanonane-1-yle ou
le diacétate de propane-1,3-diyle.

18. Composition selon la revendication 1, dans laquelle la quantité de composé organique non-alicyclique (c) est de 2 à 150 % en poids du polymère (a).

19. Composition selon la revendication 1, dans laquelle la quantité de l'agent sensibilisant est de 2 à 150 % en poids du polymère (a).
